# EUROPÄISCHE PATENTSCHRIFT

(11) **EP 2 092 810 B1**
(45) Veröffentlichungstag und Bekanntmachung des Hinweises auf die Patenterteilung: **25.12.2013**
(21) Anmeldenummer: 07846548.1
(22) Anmeldetag: 13.11.2007
(51) Int. Cl.: H05K 3/10, H05K 3/22, H05K 3/32, B23K 20/00

(54) **ANLAGE ZUR HERSTELLUNG EINER LEITERPLATTE MIT ADDITIVEN UND INTEGRIETEN UND MITTELS ULTRASCHALL KONTAKTIERTEN KUPFERELEMENTEN**
INSTALLATION FOR PRODUCING A CIRCUIT BOARD COMPRISING ADDITIONAL COPPER WIRING ELEMENTS THAT ARE INTEGRATED AND BROUGHT INTO CONTACT BY ULTRASOUND
INSTALLATION DE FABRICATION D'UNE CARTE DE CIRCUITS IMPRIMÉS DOTÉE D'ÉLÉMENTS DE CÂBLAGE EN CUIVRE ADDITIONNELS INTÉGRÉS ET MIS EN CONTACT PAR ULTRASONS

(30) Priorität: 13.11.2006 DE 102006053696
(43) Veröffentlichungstag der Anmeldung: 26.08.2009
(73) Patentinhaber: Häusermann GmbH, 3571 Gars am Kamp (AT)
(72) Erfinder: OBERENDER, Lothar, 13467 Berlin (DE); JANESCH, Rudolf, 3571 Gars am Kamp (AT); STRUMMER, Erich, 3571 Gars am Kamp (AT); HACKL, Johann, 3571 Gars am Kamp (AT)
(74) Vertreter: Riebling, Peter
(86) Internationale Anmeldenummer: PCT/EP2007/009714
(87) Internationale Veröffentlichungsnummer: WO 2008/058674

(56) Entgegenhaltungen:
- DE-A1-102005 003 370
- JP-A- 57 091 533
- US-A- 4 976 392
- US-A- 5 868 300

## Beschreibung

Gegenstand der Erfindung ist eine Anlage zur Herstellung einer Leiterplatte mit zumindest einer zusätzlichen elektrisch leitfähigen Struktur in Form eines runden oder rechteckigen elektrisch leitfähigen Verdrahtungselementes, insbesondere in Form eines länglichen Kupferbeziehungsweise kupferhaltigen Elementes, das als additives Element zumindest stückweise flächig auf Kupferfolienelemente mittels Ultraschall kontaktiert wird und in einem weiteren Leiterplattenherstellverfahren mittels Lamination in eine Leiterplatte integriert wird.

In der WO02067642A1 beziehungsweise der DE10108168C1 wird ein Verfahren zur Herstellung einer Multiwire-Leiterplatte genannt, bei dem auf einer Seite eines dünnen Flächenelementes aus elektrisch leitendem Material mittels voneinander beabstandeter Klebeflächen Leitungsdrähte definiert verlegt und an vorgegebenen Kontaktstellen des Flächenelementes elektrisch mittels Schweißen, Bonden, Löten, Leitkleben o.dgl. kontaktiert werden.

Auf den fixierten Leitungsdrähten wird ein mechanisches Stabilisierungselement in Form eines Prepregs oder in Form eines mittels Isolierfolie aufgebrachten, elektrisch leitenden oder isolierenden Flächenelementes vorgesehen. Das Flächenelement wird dabei von der anderen Seite her derart strukturiert, dass die Kontaktstellen vom übrigen Flächenelement getrennt werden. Es werden Leitungsdrähte mittels Klebeflächen definiert verlegt.

Bei der genannten Druckschrift besteht der Nachteil, dass die an sich rund profilierten Leitungsdrähte mit Hilfe einer Verschweißung oder einer Bondverbindung elektrisch leitfähig mit den übrigen Teilen der Leiterplatte verbunden sind. Damit besteht jedoch der Nachteil, dass ein relativ dünner und runder Drahtquerschnitt auf einer großflächigen, metallisierten Kupferplatte nur punktweise kontaktiert werden kann.

Dies führt zu hohen Temperaturen an der Kontaktstelle und einer entsprechenden Wärmebelastung im Bereich der Leiterplatte, was zu Verwerfungen im Bereich der Kupferfolie und auch im Bereich der umliegenden Kunststoff-Materialien führt. Die Leiterplatte neigt deshalb zur Verwerfung an den genannten Kontaktstellen, und bei einer späteren fotolithografischen Bearbeitung der Platte ist eine ebene Oberfläche der Platte nicht mehr gegeben. Damit besteht der Nachteil, dass keine feinen Strukturen fehlerfrei auf die Oberfläche der Leiterplatte aufgebracht werden können. Damit wird die Ausschussquote sehr hoch.

In der WO06077167A2 beziehungsweise der DE102005003370A1**,** wird ein Verfahren zur durchgehenden Verlegung wenigstens eines isolierten Leitungsdrahts zwischen auf einer Leiterplatte angeordneten elektrischen Anschlussstellen sowie eine Vorrichtung zur Ausführung des Verfahrens genannt.

Dabei wird ein Verfahren zum Verschweißen eines Leitungsdrahts mit einer leitfähigen Folie beschrieben, welches vorzugsweise zur Verbindung mit einem Leiterplattenträger zur Herstellung einer Leiterplatte bestimmt ist, wobei die Dicke oder der Durchmesser des Leitungsdrahtes vorzugsweise größer ist als die Dicke der leitfähigen Folie und wobei die leitfähige Folie sich zumindest während des Verschweißens mit einer thermischen Trennplatte in Kontakt befindet, deren Wärmeleitfähigkeit geringer ist als die der leitfähigen Folie.

Es wird also ein Verfahren und eine Vorrichtung auf Basis einer Widerstandsschweißung, jedoch nicht ein US-Schweißverfahren beschrieben, da nur bei einem elektrischen Widerstandsschweißverfahren eine thermische Trennplatte in Kontakt mit einer leitfähigen Folie benötigt wird.

Insbesondere kann eine Trennplatte bei einer Ultraschallverschweißung auf einer bereits geätzten Innenlage mit einer Epoxid-Glasgewebe Struktur auf der Rückseite keine gute thermische Ableitung bewirken, da eine derartige Struktur thermisch sehr schlecht leitet.
Die Druckschrift JP 57-91533 offenbart eine Anlage zur Herstellung einer Leiterplatte, welche eine Vorrichtung zur die Trennung eines Drahtelementes beschreibt. Die Anlage zeigt jedoch nicht einen Ultraschall-Sonotrodenkopf mit einer Niederhaltevorrichtung.
Mit der Druckschrift DE 10 2005 00 370 A1 beschreibt eine Anlage zur Herstellung einer Leiterplatte mit zumindest einer zusätzlichen elektrisch leitfähigen Struktur in Form eines runden oder rechteckigen elektrisch leitfähigen Verdrahtungselementes, insbesondere in Form eines länglichen Kupfer- beziehungsweise kupferhaltigen Elementes, das als additives Verdrahtungselement zumindest stückweise flächig auf Kupferfolienelemente kontaktiert wird und in einem weiteren Leiterplattenherstellverfahren mittels Lamination in eine Leiterplatte integriert wird. Die Druckschrift offenbart jedoch keine Anlage, welche eine Kerbvorrichtung und eine Abreisvorrichtung, sowie einen Sonotrodenkopf mit einer Niederhaltevorrichtung aufweist, die zur Halterung des Verdrahtungselements dient.
Mit der Druckschrift US 4,976,392 wird eine Anlage gezeigt, die ein Zuführsystem zum Zuführen eines Verdrahtungselementes, eine Kerbvorrichtung und eine Abreisvorrichtung aufweist. Ein Ultraschall-Sonotrodenkopf mit Niederhaltevorrichtung wird beispielsweise mit der Figur 15 gezeigt, wobei unter dem Bezugszeichen 90 ein Schweißwerkzeug abgebildet ist, welches ein rundes Verdrahtungselement (96) führt bzw. niederhält.

Aufgabe der vorliegenden Erfindung ist daher die Schaffung einer Anlage zur kostengünstigen Herstellung von multifunktionellen Leiterplatten zur Verdrahtung von hochkomplexen Leiterstrukturen, insbesondere Fein- bis Feinstleiterstrukturen, gemeinsam mit Strukturen zur Leitung relativ hoher Ströme auf einer Platine.

Dieses Ziel wird durch eine Anlage gemäß Anspruch 1 erreicht.

In einer ersten Ausführungsform wird eine Anlage bestehend aus einem Tisch und einem horizontal angeordneten Sonotrodenkopf mit Ultraschallgenerator und einem Zuführsystem inklusive Niederhaltesystem und einem Abreißsystem für das Verdrahtungselement beschrieben.

In einer zweiten Ausführungsform wird der Sonotrodenkopf mit Ultraschallgenerator vertikal angeordnet und mit einem Torsionsschwingsystem werden großflächigere intermetallische Verbindungen mittels Ultraschallenergie verschweißt.

Beide Ausführungsformen können in ein System integriert werden oder können getrennt oder auch sequentiell in einer Mehrfachanlage ausgeführt sein und bei beiden Systemen kann nur der Sonotrodenkopf oder nur der Tisch in x und y Richtung verfahren werden oder es kann der Sonotrodenkopf in eine Richtung und der Tisch in die andere Richtung verfahrbar ausgeführt werden.

In einer weiteren Ausbildungsform wird die Tischplatte wechselbar ausgeführt und können derart Abnützungen durch die Pressung während der Ultraschallkontaktierung rasch bereinigt werden.

Die Sonotrodenwerkzeuge, sind wechselbar ausgeführt und es kann dabei ein vollautomatischer Werkzeugwechsler verwendet werden. Die Formen der Sonotroden werden dabei dreiecksförmig beziehungsweise trapezförmig ausgebildet und somit können runde beziehungsweise rechteckige Verdrahtungselemente im Bereich der Ultraschallverbindungen so verformt werden, dass die Kontaktflächen der Verdrahtungselemente zur Kupferfolienfläche bedeutend größer ist als die Kontaktfläche ohne eine derart ausgebildete Sonotrodenform. Durch die Vergrößerung der Kontaktfläche wird eine wesentlich bessere Stromverteilung und thermische Ankoppelung an die Kupferfolie erzielt.

Erfindungsgemäß wird dabei zumindest ein längliches Verdrahtungselement mittels einer speziell geformten Sonotrode im zumindest stückweise flächigen Kontaktbereich derart im Querschnitt verformt, dass die Kontaktfläche gegenüber der darunter liegenden Folie um vorzugsweise 20% erhöht wird. Weitere bevorzugte Ausführungen sehen sogar eine Erhöhung der Kontaktfläche um mehr als 30% und ganz besonders um mehr als 50% gegenüber einer nicht verformten (linienförmigen) Kontaktfläche (eines Runddrahtes) vor.

In einer speziellen Ausführungsform wird das Verdrahtungselement im Querschnitt etwa dreiecksähnlich beziehungsweise trapezförmig verformt. Dadurch wird die gewünschte Vergrößerung der Kontaktfläche erreicht.

Mit der Verwendung von Verdrahtungselementen, deren Querschnitt von der Rundform abweicht ergeben sich wesentliche Vorteile:

Wie eingangs beschrieben, entstehen beim Verschweißen rundprofilierter Verdrahtungselementen auf einer ebenen Folie - bedingt durch die linienförmige Kontaktfläche - so starke Wärmebelastungen auf der ebenen Folie, dass diese beschädigt wird.

Hier setzt die Erfindung ein, die vorsieht, dass mit den erfindungsgemäßen Einrichtungen der Anlage die Verdrahtungselemente mindestens an der Stelle ihrer Verschweißung auf der ebenen Folie an dieser Stelle abgeflacht werden und die Rundform an dieser Stelle verlieren.

Erfindungsgemäß werden dreiecksförmige oder trapezförmige Verformungen vorgesehen, mit dem Ziel, die stumpfe (und annährend abgeflachte) Seite des Verdrahtungselementes mit größerer Oberfläche auf der ebenen Folie aufzusetzen und dort zu verschweißen. Damit werden die Wärmeübergänge auf eine größere Fläche verteilt und es besteht keine Gefahr der Beschädigung der empfindlichen Folie. Sofern eine Widerstandsverschweißung angewendet wird, kann dann sogar die Schweißstromstärke erhöht werden, ohne dass die Gefahr besteht, dass die empfindliche CU-Folie beschädigt wird.

Zwar könnte man durchgehend Verdrahtungselemente verwenden, deren Querschnitt über die gesamte Länge von der Rundform abweicht, dies hat aber verschlechterte Stromleitungseigenschaften zur Folge. Aus diesem Grund sollen die Verdrahtungselemente mit einer daran angepassten Sonotrode nur am Ort ihrer Verschweißung auf der Kupferfolie eine abgeflachte Form erhalten.

Eine Sonotrode, die am Ort der Verschweißung eines Runddrahtes aus diesem eine abgeflachte Form gestaltet, hat zum Beispiel einen dreiecksförmigen Querschnitt mit einer Länge von etwa 2 - 3 mm. Die Tiefe der V-förmigen Ausnehmung in der Sonotrode muss jedoch kleiner sein als der Durchmesser des darin aufgenommene Querschnitt des dreiecksförmig verformten Drahtes. Ein solcher Runddraht hat beispielsweise einen Durchmesser von 500µm. Damit wird vermieden, dass die Sonotrode selbst auf der CU-Folie aufliegt, was diese andernfalls beschädigen würde.

Die Sonotrode muss eine großflächige Anlage auf der CU-Oberfläche des zu verformenden Drahtes gewährleiten, ansonsten die Reibschweißenergie nicht ausreichend übertragen werden könnte. Durch den Druck der Sonotrode auf den runden Querschnitt des Kupferleiters (Verdrahtungselement) und durch die US-Energie wird der Querschnitt abgeflacht und mit seiner abgeflachten Breitseite auf die Oberfläche der CU-Folie aufgepresst und dort durch Reibschweißung stoffschlüssig angeschweißt. Damit wird eine wesentlich größere Auflagefläche in der Ankoppelung an die darunter liegende CU-Folie erreicht.

Diese CU-Folie hat dabei eine Dicke von lediglich 9 oder 17oder 35 µm. Diese Angaben beziehen sich auf standardisierte Dicken üblich verwendeter CU-Folien.

Selbstverständlich bezieht sich die Verformung eines Runddrahtes in ein (abgeflachtes) dreiecksförmiges Profil am Ort seiner Verschweißung auf der CU-Folie nur auf eine bevorzugte Ausführung der Erfindung. Die Erfindung umfasst jedoch alle abgeflachten Profilformen von derartigen Runddrähten. Insbesondere auch Recht- oder Quadratprofile oder auch ovale, trapez- und parallelogrammartige Profilformen.

Die Verdrahtungselemente werden bevorzugt von einer Rolle NC gesteuert zugeführt, können jedoch auch grundsätzlich als vorgefertigtes Element aus einem Magazin stückweise zugeführt werden.

Bei der Verwendung von bandförmigen Verdrahtungselementen wird das Ablängen mittel Vorkerbung beziehungsweise einem Teileinschnitt und einem anschließenden Abreißen mit einem speziellen Niederhaltesystem über einen bestimmten Winkel verwendet.

In einer Weiterbildung der Erfindung wird der Folienbereich, auf den ein Verdrahtungselement stückweise flächig appliziert werden soll, mittels einer Reinigungs-Sonotrode aus Titan vorgereinigt und dabei wird die dünne Oxidschicht, die sich auf nicht passivierten Kupferflächen innerhalb weniger Stunden bildet, eliminiert und so kann in einem anschließenden Ultraschall-Verbindungsprozess eine gute flächige Ultraschallverbindung erzielt werden.

In einer weiteren Ausbildung der Erfindung werden die bandförmigen Verdrahtungselemente während des Verlegevorgangs mehrfach und mit vorgegebenen Abständen mittels Ultraschall auf die darunter befindliche Kupferfolie kontaktiert und es kann dabei eine Abwinkelung von beispielsweise 45° und darunter und darüber realisiert werden. Demzufolge können die Verdrahtungselemente nicht nur in einer Linie, sondern mit entsprechend vorgegebenen Geometrien verlegt werden.

Verfahrenstechnisch ist bei derartigen Verlegeprozessen die Verweildauer der Sonotrode nach dem Ultraschallverschweißprozess ein wesentliches Kriterium. Derartige US-Sonotroden weisen gegenüber dem Verlegedrahtelement und der darunter befindlichen Kupferfolie eine größere Masse auf und weisen eine gute thermische Ableitung auf und können überdies so ausgebildet werden, dass eine passive oder aktive erhöhte Wärmeableitung eingerichtet wird. Derart kann auch bei einer großen Anzahl zeitlich kurz beabstandeter Ultraschallverschweißungen verhindert werden, dass die Sonotrode zu stark erwärmt wird, somit kann die Sonotrode allfällige Wärmeentwicklung in den Schweißpartnern ableiten. Die Verweildauer ist überdies für den Abreißprozess oder einen Biegeprozess von Vorteil, da dabei die Schweißstelle zusätzlich durch eine entsprechende Anpresskraft stabilisiert wird.

Die Erfindung bezieht sich demnach auch auf eine Leiterplatte mit zusätzlichen funktionalen Elementen. Dabei wird eine hochkomplexe feine Struktur auf einer Leiterplatte mit der Möglichkeit der Verdrahtung von Hochstrom führenden Bauteilen auf einer Platine beschrieben.

Es wird weiters die Wärmeableitung durch die Ausbildung derartiger zusätzlicher Elemente auf und/oder in einer Leiterplatte beschrieben und deren Anwendung für die Kontaktierung von Bauteilen zwecks Wärmeableitung.

Dabei wird ein Mechanismus zum Niederhalten vor der nachfolgenden US-Schweißung verwendet, um die Ausbreitung der US-Energie in Richtung der vorher gehenden Schweißstelle zu dämpfen und gleichzeitig das Substrat auf der Unterlage zu halten.

In einer ersten Ausführungsvariante werden elektrisch leitfähige Verdrahtungselemente mittels Reibschweißverfahren oder Ultraschallschweißverfahren bevorzugt flächig auf eine darunter befindlichen ätztechnisch hergestellten Leiterstruktur befestigt und anschließend mittels entsprechender Harzsysteme einebnend bearbeitet.

In einer zweiten Ausführungsvariante werden elektrisch leitfähige Verdrahtungselemente mittels Reibschweißen beziehungsweise Ultraschall isolierend auf einem Leiterplattensubstrat befestigt. Dabei kann die Isolationsschicht vollflächig oder selektiv auf der entsprechenden Leiterplattenoberfläche angeordnet sein oder es kann das elektrisch leitfähige Verdrahtungselement auf der entsprechenden Seite oder umhüllend mit einem entsprechenden Harz versehen sein. Auf diese Weise wird eine eigenständige Verdrahtungsebene hergestellt. Die anschließende Einebnung mittels geeigneter Harzsysteme kann wie in der ersten Ausführungsvariante erfolgen.

In einer weiteren Ausbildung der vorliegenden Erfindung werden insbesondere flache Verdrahtungselemente als selektive wärmeableitende Elemente verwendet. Dabei sind flächige Elemente in eine Innenlage oder auf einer der beiden Oberflächen positioniert und es wird im Anschluss an die Einebnung beziehungsweise Lamination eine Öffnung derart hergestellt, dass der jeweilige Bauteil in direktem wärmeleitendem Kontakt montiert werden kann.

Die Erfindung wird nun anhand mehrerer Ausführungsbeispiele näher beschrieben. Hierbei gehen aus den Zeichnungen und ihrer Beschreibung weitere Vorteile und Merkmale hervor.

Alle in den Unterlagen, einschließlich der Zusammenfassung offenbarten Angaben und Merkmale, insbesondere die in den Zeichnungen dargestellte Ausbildung, werden als erfindungswesentlich beansprucht, soweit sie einzeln oder in Kombination gegenüber dem Stand der Technik neu sind.

Einige Ausführungsbeispiele der Erfindung werden nachfolgend anhand der Zeichnungsfiguren näher beschrieben.

Dabei zeigen:
Figur 1: eine schematische Darstellung eine Anlage (1) zur Herstellung einer Leiterplatte (2) mit zumindest einer zusätzlichen elektrisch leitfähigen Struktur (4) in Form eines runden oder rechteckigen elektrisch leitfähigen Verdrahtungselementes (4) unter Verwendung eines horizontal angeordneten Ultraschall-Sonotrodensystems auf Basis eines Torsionsschwingsystems bzw. eines Longtidutionalsystems (5) für die Verschweißung von kleineren Verdrahtungselement (4) Querschnitten,
**Figur 2****:** eine schematische Darstellung eine Anlage (1) zur Herstellung einer Leiterplatte (2) mit zumindest einer zusätzlichen elektrisch leitfähigen Struktur (4) in Form eines runden oder rechteckigen elektrisch leitfähigen Verdrahtungselementes (4) unter Verwendung eines vertikal angeordneten Ultraschall-Sonotrodensystems (6) auf Basis eines Torsionsschwingsystems bzw. eines Longtidutionalsystems für die Verschweißung von größeren Verdrahtungselement (4) Querschnitten,
**Figur 3****:** eine schematische Darstellung eine Anlage (1) zur Herstellung einer Leiterplatte (2) mit zumindest einer zusätzlichen elektrisch leitfähigen Struktur (4) in Form eines runden oder rechteckigen elektrisch leitfähigen Verdrahtungselementes (4), wobei in dieser Darstellung eine Ultraschall-Sonotroden-Kerb-Spulen-Einheit (16) zusammengefasst aufgezeigt ist und diese Einheit (16) drehbar um bis zu 360° ausgeführt ist und derart eine abgewinkelte Verlegung eines Verdrahtungselementes (4) möglich ist,
**Figur 4****:** eine schematische Darstellung des Kerb-Abreißprinzips,
**Figur 5****:** eine Draufsicht auf eine Musterplatine (25) aus vollflächiger und nicht geätzter 70 µm dicker Kupferfolie (20) mit stückweise ultraschallverschweißten (21) 500 µm Kupferdrähten (4),
**Figur 6****:** einen Ausschnitt (26) aus der Draufsicht auf die Musterplatine (25) aus Figur 5 mit einer Detailansicht der flächigen Ultraschallkontaktstellen (21) inklusive der Abrißenden (24) der Verdrahtungselemente (4) und der Abwinkelungen (23).
**Figur 7****:** schematisch einen Schnitt durch ein Substrat (2) mit einer Leiterbahn (4) mit einem runden Draht (3) und einer darüber angeordneten Sonotrode (18) vor der Kontaktierung dargestellt.
**Figur 8****:** schematisch einen Schnitt durch ein Substrat (2) mit einer Leiterbahn (4) mit einem runden Draht (3) und einer darüber angeordneten Sonotrode (18) nach der Kontaktierung dargestellt.

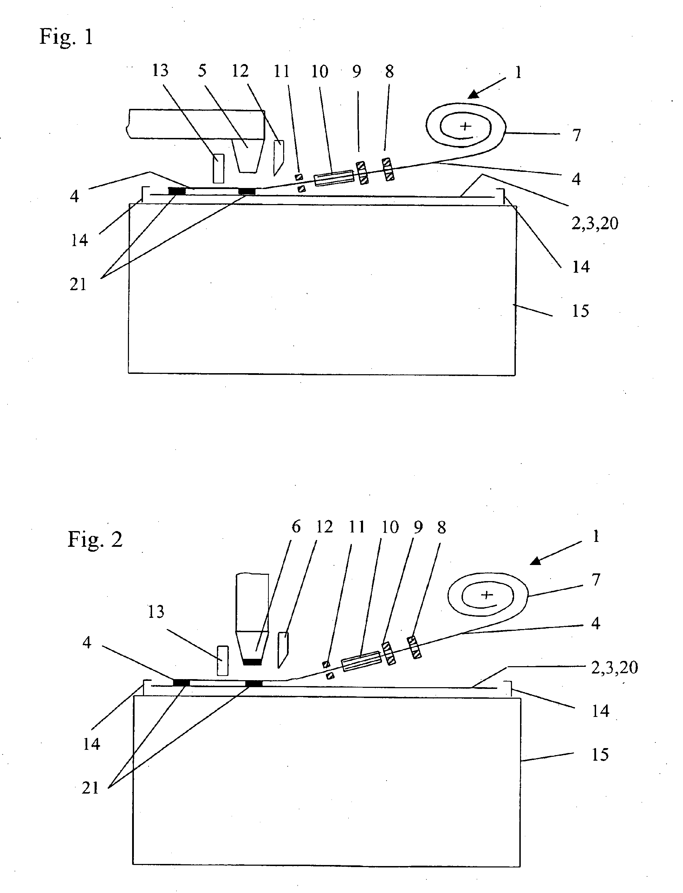

In **Figur 1** wird eine schematische Darstellung eine Anlage (1) zur Herstellung einer Leiterplatte (2) mit zumindest einer zusätzlichen elektrisch leitfähigen Struktur (4) in Form eines runden oder rechteckigen elektrisch leitfähigen Verdrahtungselementes (4) unter Verwendung eines horizontal angeordneten Ultraschall-Sonotrodensystems (5) für die Verschweißung von kleineren Verdrahtungselement (4) Querschnitten aufgezeigt.

Dabei wird eine multifunktionelle Leiterplatte (2) im noch nicht fertigen Zustand beziehungsweise ein Substrat (3) mit einer vollflächigen oder bereits strukturierten Kupferfolie (20) auf einem Tisch (15) positioniert beziehungsweise mit einem Klemm- beziehungsweise Registriersystem (14) positioniert und festgehalten. Anstelle eines Klemmsystems (14) oder zusätzlich zu diesem kann ein Tisch mit Vakuumansaugung verwendet werden oder kann ein Hilfsträger verwendet werden.

Der Tisch (15) ist bezogen auf das Sonotroden-Ultraschall-System (5) in x-y-z Richtung NC-gesteuert verfahrbar, wobei in einer ersten Ausführungsform der Tisch für die Ein- und Ausgabe der Leiterplatte (2) beziehungsweise des Substrates (3) mit der Kupferfolie (20) verwendet wird und das gesamte Oberwerk bestehend aus dem Sonotrodensystem (5), dem Niederhalter (13), dem Kerbsystem (12), dem Klemmsystem (11), der Führung (10), der ersten und zweiten Öse (8, 9) und der Spule (7) verfahrbar ausgeführt ist und zusätzlich ein Teil davon um 360° drehbar ist und derart ein abgewinkeltes Verlegen eines Verdrahtungselementes (4) möglich ist.

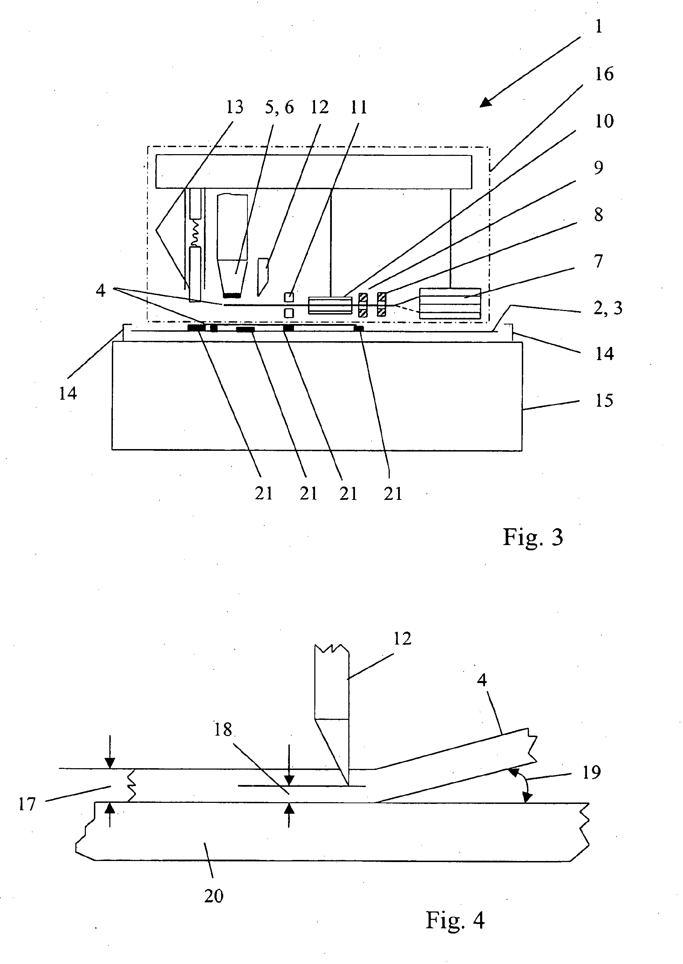

In dieser schematischen Darstellung wird die Spule (7) vertikal angeordnet aufgezeigt, sie kann jedoch ebenso gut horizontal wie in Figur 3 aufgezeigt angeordnet werden. In beiden Fällen werden die Ösen (8, 9) dazu verwendet, den unterschiedlichen Wickeldurchmesser einer Spule (7) mit beispielsweise 100 m Verdrahtungselement (4) auszugleichen und diesen gerade in das Führungselement (10) einzuführen.

Das Klemmsystem (11) ist in dieser Darstellung mit Klemmbacken von oben und unten aufgezeigt, wird jedoch je nach verwendetem Verdrahtungselementquerschnitt (4) optimiert ausgeführt und kann derart auch seitlich beziehungsweise mehrfach ausgeführt werden. In einer bevorzugten Ausführung wird das Klemmsystem (11) derart ausgeführt, dass das Verdrahtungselement (4) unter einem Winkel von wenigen Grad bis zu etwa 20° nach oben wirkend ausgeführt ist. Damit wird der Abreißvorgang mittels Kerbsystem (12) einfacher und besser.

Das Kerbsystem (12) kerbt beziehungsweise schneidet das Verdrahtungselement (4) nicht vollständig durch, da toleranzbedingt eine Ankerbung der darunter befindlichen Leiterplatte (20) nicht vermieden werden kann. Das Kerbsystem (12) wird daher mit einem gewissen Sicherheitsabstand von der Kupferoberfläche (20) das Verdrahtungselement (4) mit zumindest einer Kerbung mit mehr als der Hälfte der Höhe des Verdrahtungselementes (4) ausführen.

Beim Vorgang des Abreißens des Verdrahtungselementes (4) klemmt die Sonotrode (5) das Verdrahtungselement (4) im Bereich der flächigen Ultraschallkontaktstelle (21) mit auf den Tisch (15) beziehungsweise gegen den Tisch (15).

Es wurde festgestellt, dass ein Einkerben eines Segmentes, das auf der Kupferfolie befestigt ist, mit großen Schwierigkeiten verbunden ist. Wird das teilweise Segment eingekerbt, ohne es mit seinem freien Ende von der Oberfläche der Kupferfolie abzuheben, dann ist bei einem nicht eingekerbten Restquerschnitt von 25 % die notwendige Abreißkraft so groß, dass eine Deformation der Kupferfolie in Kauf genommen werden muß.

Wird hingegen das freie Ende von der Oberfläche abgehoben, wobei der teilweise Kerbschnitt im nicht-angehobenen Teil des Segmentes erfolgt, dann ist die Abreißkraft wesentlich geringer, wenn wiederum von einer Einkerbung mit einer Tiefe von 75 % der Materialstärke ausgegangen wird.

Verfahrenstechnisch wird also zunächst das freie Ende des Segmentes von der Oberfläche der Kupferfolie abgehoben und der teilweise Kerbschnitt im noch auf der Oberfläche der Kupferfolie aufliegenden Teil des Segmentes durchgeführt. Danach wird das teilweise eingekerbte und von der Oberfläche der Kupferfolie abgehobene Ende abgerissen.

In der maschinellen tatsächlichen Ausführung sind die Abstände, im Gegensatz zu dieser schematischen Darstellung, zwischen dem Ende der Führung (10), dem Klemmsystem (11), dem Kerbsystem (12), dem Sonotrodenwerkzeug (5) und dem Niederhalter (13) sehr gering beziehungsweise eng beabstandet, sodaß eine exakte und NC-gesteuerte Positionierung eines abgelängten Verdrahtungselementes (4) auf der Oberfläche eines Kupferfolienelementes (20) und deren flächige Verschweißung möglich ist.

Die Ultraschallverschweißung erfolgt bei Verwendung von runden Drahtelementen (4) mit entsprechend dreieckförmigen oder trapezförmigen Sonotroden, so dass der Kontaktbereich (21) wesentlich größer wird verglichen mit der linienförmigen Kontaktierung eines runden Drahtelementes (4) auf einer plangeraden Kupferoberfläche (20).

In **Figur 2** wird eine schematische Darstellung eine Anlage (1) zur Herstellung einer Leiterplatte (2) mit zumindest einer zusätzlichen elektrisch leitfähigen Struktur (4) in Form eines runden oder rechteckigen elektrisch leitfähigen Verdrahtungselementes (4) unter Verwendung eines vertikal angeordneten Ultraschall-Sonotrodensystems (6) auf Basis eines Torsionsschwingsystems bzw. eines Longitudionalsystems für die Verschweißung von größeren Verdrahtungselement (4) Querschnitten aufgezeigt. Bei diesem System können beispielsweise auch flächige Drahtelemente (4) mit einem Querschnitt von einigen Millimetern bis etwa 10 mm und typisch 2 bis 5 mm Breite bei einer Dicke von einigen 100 µm, typisch im Bereich von etwa 200 bis 500 µm, verlegt werden. Dabei hat sich ein Torsionsschwingungs-Ultraschallsystem (6) bewährt. Die entsprechenden Sonotroden (6) werden dabei mit einer entsprechenden Oberflächenstruktur versehen, so dass eine gute Ultraschall-Reibschweiß-Energieeinbringung möglich ist und die Oberfläche des Verdrahtungselementes (4) nur kleine Abdrücke beziehungsweise Einkerbungen aufweist. Überdies kann auch bei einem flachförmigen Verdrahtungselement (4) die Sonotrode (6) trapezförmig gestaltet werden. Damit werden die seitlichen Bereiche des Verdrahtungselementes (4) abgeschrägt geformt und in einem Leiterplattenlaminierverfahren erfolgt eine bessere Harzeinbettung.

In **Figur 3** wird eine schematische Darstellung eine Anlage (1) zur Herstellung einer Leiterplatte (2) mit zumindest einer zusätzlichen elektrisch leitfähigen Struktur (4) in Form eines runden oder rechteckigen elektrisch leitfähigen Verdrahtungselementes (4), wobei in dieser Darstellung eine Ultraschall-Sonotroden-Kerb-Spulen-Einheit (16) zusammengefasst aufgezeigt ist und diese Einheit (16) drehbar um bis zu 360° ausgeführt ist und derart eine abgewinkelte Verlegung eines Verdrahtungselementes (4) möglich ist. Dabei kann grundsätzlich auch das Sonotrodensystem (5, 6) inklusive Niederhalter (13) nicht drehbar ausgeführt werden beziehungsweise wahlweise drehbar ausgeführt werden und werden die anderen Elemente NC gesteuert entsprechend der gewünschten Abwinkelung des Verdrahtungselementes (13) gedreht.

In **Figur 4** wird eine schematische Darstellung des Kerb-Abreißprinzips aufgezeigt. Dabei wird eine Kerbschneide (12) NC gesteuert abgesenkt und kerbt das Drahtelement (4) mit der Höhe (17) bis auf eine Einkerbtiefe (18) ein. Mit der Einkerbtiefe (18) wird die restliche nicht gekerbte Höhe des Drahtelementes (4) verstanden, die mittels Klemmsystem (11) abgerissen wird.

Die Einkerbtiefe (18) wird derart bemessen, dass gesichert keine Einkerbung beziehungsweise Berührung der Oberfläche der Kupferfolie (20) erfolgt. Umgekehrt wird die Einkerbung zumindest 50% der Höhe (17) eines Verdrahtungselementes (4) betragen und wird damit und es wird erfindungsgemäß durch die Anwinkelung (19) des Klemmsystems (11) und der Kerbwirkung eine geringere Abreißkraft erreicht. Würde lediglich ein Restquerschnitt von 25 % nicht eingekerbt und versucht, das gerade, nicht von der Oberfläche abgehobene Ende des Verdrahtungselementes abzureißen, würde sich die Kupferfolie 20 verformen. Dies wird mit dem Anheben des freien Endes um den Anhebewinkel 19 vermieden. Die notwendige Abreißkraft ist geringer und eine Verformung der Kupferfolie 20 wird vermieden.

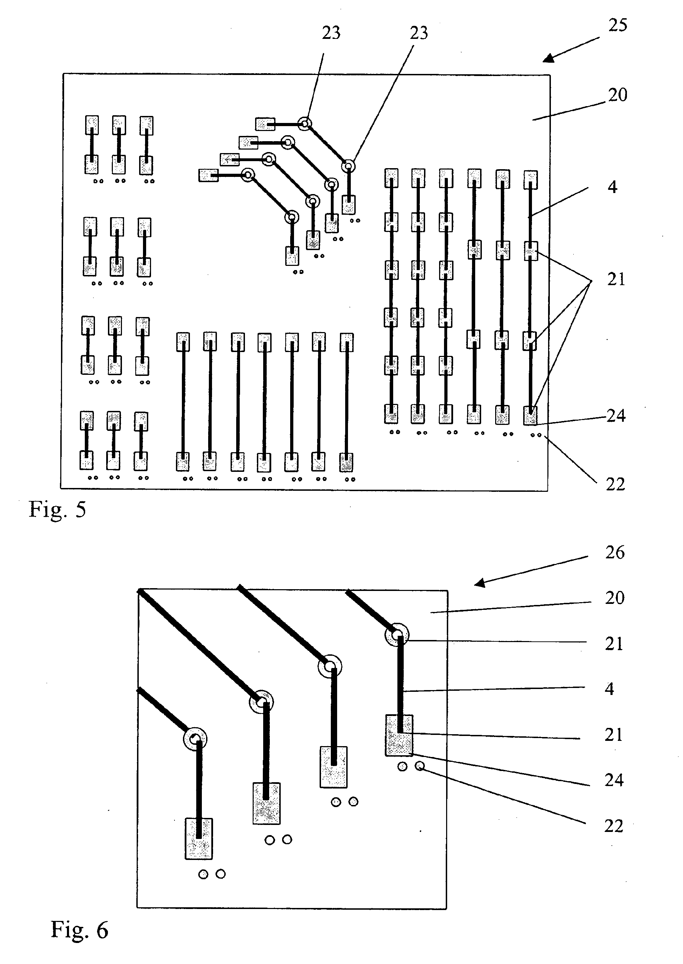

In **Figur 5** wird eine Draufsicht auf eine Musterplatine (25) aus vollflächiger und nicht geätzter 70 µm dicker Kupferfolie (20) mit stückweise ultraschallverschweißten (21) 500 µm Kupferdrähten (4) aufgezeigt. Diese Musterplatine (25) wurde mit einer Vielzahl von Varianten ausgeführt. Die Aufnahme zeigt die Kontaktierung von 500 µm dickem Kupferrunddraht (4) auf einer 70 µm dicken Kupferfolie (20) auf, die nicht strukturiert ist und die keinen Harzträger aufweist. Eine derartige Kupferfolie (20) wird nach der Applikation der Drahtelemente (4) einem Laminationsvorgang unterzogen und ätztechnisch an der den Drahtelementen (4) gegenüberliegenden Seite strukturiert beziehungsweise werden die Drahtelemente (4) beim Laminiervorgang in einer Leiterplattenpresse nach dem Stand der Technik in der Harzlage eingebettet.

In Figur 5 sind einzelne Runddrahtelemente (4) mittels Ultraschall in unterschiedlichen Abständen auf die Kupferfolie (20) kontaktiert. Diese Versuche pro Drahtquerschnitt dienen zur Optimierung der Sonotrode beziehungsweise der Niederhalter der Drahtelemente (4) für eine möglichst plane Verlegung, das heißt, dass die Drahtelemente (4) zwischen den einzelnen flächigen Ultraschallkontaktstellen (21) möglicht im Linienkontakt auf der Kupferoberfläche (4) angeordnet werden.

Weiters wird in Figur 5 die gewinkelte Verlegung aufgezeigt. Dabei wird der Sonotrodenkopf (5, 6) inklusive der Drahtzuführung um beispielsweise 45° gedreht oder aber der Tisch mit der Kupferfolie (20) wird gedreht. Gleichzeitig muss der Draht (4) gebogen werden. Er muss also beim Ultraschallschweißvorgang mechanisch so lange niedergehalten werden, bis der Biegevorgang beendet ist. Ein Ultraschallweißvorgang ist zwar ein weitgehend kalter Schweißvorgang, allerdings wird im Bereich der Bildung der intermetallischen Verbindung eine relativ hohe Temperatur bis in den Bereich des Schmelzpunktes von Kupfer bei 1.083°C erreicht. Da üblicherweise eine Sonotrode (5, 6) eine relativ große Masse im Vergleich zu den Drahtelementen (4) aufweist, kann die Verweildauer der Sonotrode (5, 6) nach dem Ultraschallschweißvorgang die Ableitung der erzeugten Wärme bewirken und kann überdies eine mechanische Verfestigung durch die Druckbeaufschlagung bewirken. Die US-Sonotrode (5, 6) kann überdies mit einer aktiven Kühlung versehen werden.

In **Figur 6** wird ein Ausschnitt (26) aus der Draufsicht auf die Musterplatine (25) aus Figur 5 mit einer Detailansicht der flächigen Ultraschallkontaktstellen (21) inklusive der Abrissenden (24) der Verdrahtungselemente (4) und der Abwinkelungen (23) aufgezeigt.

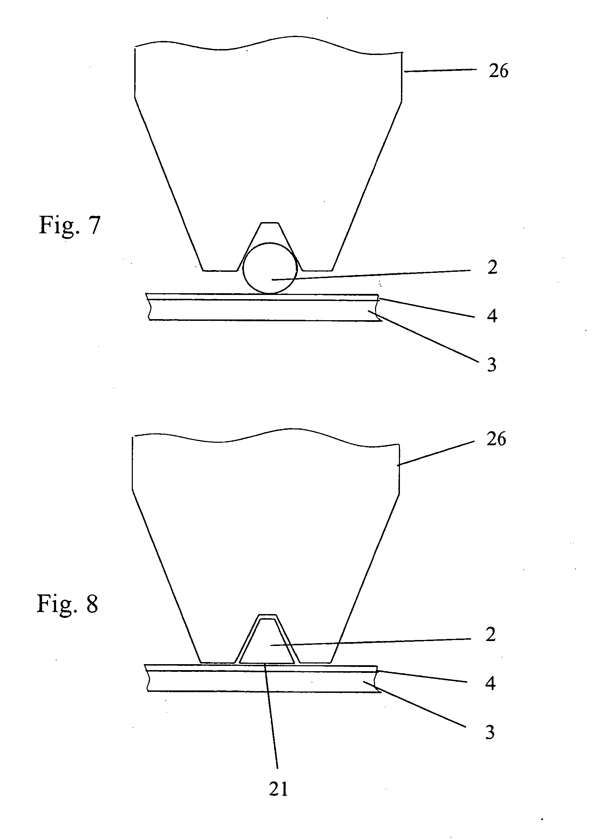

In **Figur 7** wird schematisch ein Schnitt durch ein Substrat (3) mit einer Leiterbahn (4) mit einem runden Draht (2) und einer darüber angeordneten Sonotrode (26) vor der Kontaktierung dargestellt. In dieser Darstellung berührt die Sonotrode (26) den Draht (2) nur punktuell, also gerade in dem Moment, ab dem eine Verformung mittels Ultraschall beginnt. Der Draht (2) berührt ebenfalls nur punktuell die Oberfläche der Leiterbahn (4).

In **Figur 8** wird schematisch ein Schnitt durch ein Substrat (3) mit einer Leiterbahn (4) mit einem runden Draht (2) und einer darüber angeordneten Sonotrode (26) nach der Kontaktierung dargestellt. In dieser Darstellung hat die Sonotrode (26) den Draht (2) bereits dreiecksartig geformt und der Draht (2) ist flächig mit der Oberfläche der Leiterbahn (4) durch eine intermetallische Verbindung (21) thermisch und elektrisch gut leitfähig verbunden.

### Bezugszeichenliste

- 1: Anlage zur Herstellung einer Leiterplatte mit zumindest einer zusätzlichen elektrisch leitfähigen Struktur in Form eines runden oder rechteckigen elektrisch leitfähigen Verdrahtungselementes.
- 2: Multifunktionelle Leiterplatte mit zumindest einem funktionalen Element in Form eines runden oder rechteckigen elektrisch leitfähigen Verdrahtungselementes.
- 3: Substrat: Basismaterial z.B. FR-2, FR-3, FR-4, FR-4-Low-Tg, CEM-1, CEM-x, PI, CE, Aramid, usw. bzw. Prepreg
- 4: Funktionales elektrisch und thermisch gut leitfähiges Verdrahtungselement: rund oder rechteckig bzw. bandförmig; Kupfer oder Aluminium oder elektrisch u/o thermisch gut leitfähig
- 5: Sonotrode mit horizontalem Ultrschallschweißgerät (Generator) für kleinere Verdrahtungselement-Querschnitte
- 6: Sonotrode mit vertikalem Ultraschallschweißgerät mit einem Torsionsschwingsystem für größere Verdrahtungselement-Querschnitte
- 7: Verdrahtungselement-Spule
- 8: Erste Öse
- 9: Zweite Öse
- 10: Führung
- 11: Klemmsystem zum Abreisen des Verdrahtungselementes
- 12: Kerbsystem beziehungsweise Schneidkerbsystem
- 13: Niederhalter
- 14: Klemmsystem beziehungsweise Registriersystem für das Substrat (3) beziehungsweise die multifunktionelle Leiterplatte (2)
- 15: Tisch
- 16: Ultraschall-Sonotroden-Kerb-Spulen Einheit, drehbar um bis zu 360°
- 17: Höhe des Verdrahtungselementes
- 18: Einkerbtiefe
- 19: Anhebewinkel beziehungsweise Anhebehöhe des Verdrahtungselementes beim Eingerben und Abreissen
- 20: Kupferfolie
- 21: Ultraschallkontaktstelle
- 22: Abreißstelle
- 23: Abwinklung
- 24: Abrißende
- 25: Ausschnitt
- 26: Sonotrode

## Patentansprüche

1. Anlage (1) zur Herstellung einer Leiterplatte (2), wobei die Anlage (1) ein Zuführsystem (8-10) zum Zuführen eines Verdrahtungselements (4), eine Kerbvorrichtung (12), eine Abreißvorrichtung (11) und einen Ultraschall-Sonotrodenkopf (5, 6, 26) mit Niederhaltevorrichtung (13) aufweist, und der Ultraschall-Sonotrodenkopf (5, 6, 26) eine im Querschnitt konturierte Ausnehmung zur teilweisen umfangsseitigen Umgreifung des Verdrahtungselements (4) aufweist, wobei das Verdrahtungselement (4) mit einer Ultraschallschweissverbindung auf einer Gegenfläche festlegbar ist, **dadurch gekennzeichnet, dass** die konturierte Ausnehmung im Sonotrodenkopf (5, 6, 26) als dreiecksförmige oder trapezförmige Kontur ausgebildet ist, welche das runde oder rechteckige Verdrahtungselement im Bereich der Ultraschallschweissverbindung mit einer Vergrößerung der Ultraschallkantaktstelle(21) verformt.

2. Anlage zur Herstellung einer Leiterplatte nach Anspruch 1, **dadurch gekennzeichnet, dass** ein horizontal angeordneter Sonotrodenkopf (5, 26) mit Ultraschallgenerator über einem Tisch angeordnet ist und zueinander NC-gesteuert verfahrbar ausgeführt ist.

3. Anlage zur Herstellung einer Leiterplatte nach Anspruch 1, **dadurch gekennzeichnet, dass** ein vertikal angeordneter Sonotrodenkopf (6, 26) mit Ultraschallgenerator und Torsionsschwingsystem bzw. eines Longitudinalsystems über einem Tisch angeordnet ist und zueinander NC-gesteuert verfahrbar ausgeführt ist.

4. Anlage zur Herstellung einer Leiterplatte nach einem der Ansprüche 1 bis 3, **dadurch gekennzeichnet, dass** der Sonotrodenkopf (5, 6, 26) mit Ultraschallgenerator in x- und y-Richtung NC-gesteuert verfahren wird und der Tisch nicht verfahrbar angeordnet ist.

5. Anlage zur Herstellung einer Leiterplatte nach einem der Ansprüche 1 bis 3, **dadurch gekennzeichnet, dass** der Tisch in x- und y-Richtung NC-gesteuert verfahren wird und der Sonotrodenkopf (5, 6, 26) mit Ultraschallgenerator nicht verfahrbar angeordnet ist.

6. Anlage zur Herstellung einer Leiterplatte nach einem der Ansprüche 1 bis 3, **dadurch gekennzeichnet, dass** der Tisch in eine Richtung und der Sonotrodenkopf (5, 6, 26) mit Ultraschallgenerator in die andere Richtung NC-gesteuert verfahren wird.

7. Anlage zur Herstellung einer Leiterplatte nach einem der Ansprüche 1 bis 6, **dadurch gekennzeichnet, dass** ein Substrat mit einer entsprechend ausgestalteten Kupferfolienoberfläche beziehungsweise eine entsprechende Kupferfolie manuell auf den Tisch eingelegt wird und nach dem Verlegeprozess manuell entnommen wird oder die Zu- und Abfuhr vollautomatisch erfolgt und dass das Substrat mit der Kupferfolie beziehungsweise die Kupferfolie am Tisch in einer genau definierten Position mittels Greifer- beziehungsweise Klemmsystemen festhält.

8. Anlage zur Herstellung einer Leiterplatte nach einem der Ansprüche 1 bis 7, **dadurch gekennzeichnet, dass** der Sonotrodenkopf (5, 6, 26) drehbar ausgeführt ist und derart eine abgewinkelte Verlegung von Verdrahtungselementen erfolgen kann.

9. Anlage zur Herstellung einer Leiterplatte nach einem der Ansprüche 1 bis 8, **dadurch gekennzeichnet, dass** das Sonotrodenwerkzeug wechselbar ausgeführt ist und manuell oder vollautomatisch gewechselt werden kann.

10. Anlage zur Herstellung einer Leiterplatte nach einem der Ansprüche 1 bis 9, **dadurch gekennzeichnet, dass** das Sonotrodenwerkzeug flach und aus Titan ausgebildet ist und derart bereichsweise die Oberfläche einer Kupferfolie reinigen kann und derart eine oxidische Passivationsschicht entfernt werden kann.

11. Anlage zur Herstellung einer Leiterplatte nach einem der Ansprüche 1 bis 10, **dadurch gekennzeichnet, dass** ein bereits vorgefertigtes Verdrahtungselement aus einem Magazin positionsgenau auf der Kupferoberfläche positioniert wird und anschließend mittels Sonotroden und Ultraschall stückweise verbunden wird.

12. Anlage zur Herstellung einer Leiterplatte nach einem der Ansprüche 1 bis 11, **dadurch gekennzeichnet, dass** der Sonotrodenkopf (5, 6, 26) eine Abflachung des Kontaktierungsbereiches eines runden Drahtes (2) bei der Verschweißung mit der gegenüberliegenden Fläche ausführt.

13. Verfahren zum Betrieb der Anlage zur Herstellung einer Leiterplatte nach einem der Ansprüche 1 bis 12, **dadurch gekennzeichnet, dass** eine Kerbschneide (12) NC-gesteuert abgesenkt und das Drahtelement (4) mit der Höhe (17) bis auf eine Einkerbtiefe (18) eingekerbt wird und dass die restliche nicht gekerbte Höhe des Drahtelementes (4) mittels eines Klemmsystems (11) abgerissen wird.

## Claims

1. Installation (1) for producing a circuit board (2), wherein the installation (1) has a supply system (8 to 10) for supplying a wiring element (4), a notching device (12), a separating device (11) and an ultrasonic sonotrode head (5, 6, 26) with a holding down device (13), and the ultrasonic sonotrode head (5, 6, 26) has a cross-sectionally contoured recess to partially peripherally engage around the wiring element (4), the wiring element (4) being fixable with an ultrasound welding connection on a counter-face, **characterised in that** the contoured recess in the sonotrode head (5, 6, 26) is configured as a triangular or trapezoidal contour, which deforms the round or rectangular wiring element in the region of the ultrasound welding connection with an enlargement of the ultrasound contact point (21).

2. Installation for producing a circuit board according to claim 1, **characterised in that** a horizontally arranged sonotrode head (5, 26) with an ultrasound generator is arranged above a table and can be displaced, in an NC-controlled manner, with respect to one another.

3. Installation for producing a circuit board according to claim 1, **characterised in that** a vertically arranged sonotrode head (6, 26) with an ultrasound generator and torsional vibration system or a longitudinal system is arranged over a table and can be displaced, in an NC-controlled manner, with respect to one another.

4. Installation for producing a circuit board according to any one of claims 1 to 3, **characterised in that** the sonotrode head (5, 6, 26) with an ultrasound generator is displaced, in an NC-controlled manner, in the x-direction and y-direction and the table is not displaceably arranged.

5. Installation for producing a circuit board according to any one of claims 1 to 3, **characterised in that** the table is displaced, in an NC-controlled manner in the x-direction and y-direction and the sonotrode head (5, 6, 26) with the ultrasound generator is not displaceably arranged.

6. Installation for producing a circuit board according to any one of claims 1 to 3, **characterised in that** the table is displaced in one direction and the sonotrode head (5, 6, 26) with the ultrasound generator is displaced in the other direction, in an NC-controlled manner.

7. Installation for producing a circuit board according to any one of claims 1 to 6, **characterised in that** a substrate with a correspondingly configured copper foil surface, or a corresponding copper foil, is manually laid on the table and after the laying process is manually removed or the supply and removal take place fully automatically and **in that** the substrate with the copper foil, or the copper foil, is fixed on the table in a precisely defined position by means of gripper or clamping systems.

8. Installation for producing a circuit board according to any one of claims 1 to 7, **characterised in that** the sonotrode head (5, 6, 26) is rotatable and an angled laying of wiring elements can thus take place.

9. Installation for producing a circuit board according to any one of claims 1 to 8, **characterised in that** the sonotrode tool is exchangeable and can be exchanged manually or fully automatically.

10. Installation for producing a circuit board according to any one of claims 1 to 9, **characterised in that** the sonotrode tool is flat and made of titanium and can thus, in regions, clean the surface of a copper foil and an oxidic passivation layer can thus be removed.

11. Installation for producing a circuit board according to any one of claims 1 to 10, **characterised in that** an already prefabricated wiring element from a magazine is positioned precisely on the copper surface and is then connected piece-wise by means of sonotrodes and ultrasound.

12. Installation for producing a circuit board according to any one of claims 1 to 11, **characterised in that** the sonotrode head (5, 6, 26) carries out a flattening of the contact region of a round wire (2) during welding to the opposing face.

13. Method for operating the installation for producing a circuit board according to any one of claims 1 to 12, **characterised in that** a notching cutter (12) is lowered in an NC-controlled manner and the wiring element (4) is notched at the height (17) to a notching depth (18) and **in that** the remaining unnotched height of the wiring element (4) is separated off by means of a clamping system (11).

## Revendications

1. Installation (1) pour fabriquer une carte imprimée (2), étant précisé que l'installation (1) comporte un système d'amenée (8-10) pour amener un élément de câblage (4), un dispositif d'entaillage (12), un dispositif de rupture (11) et une tête de sonotrode à ultrasons (5, 6, 26) pourvue d'un dispositif abaisseur (13), et que la tête de sonotrode à ultrasons (5, 6, 26) présente un creux à section transversale profilée pour entourer en partie l'élément de câblage (4) côté circonférence, étant précisé que l'élément de câblage (4) est apte à être immobilisé sur une surface opposée à l'aide d'une liaison par soudage par ultrasons, **caractérisée en ce que** le creux profilé prévu dans la tête de sonotrode (5, 6, 26) est conçu comme un contour triangulaire ou trapézoïdal qui déforme l'élément de câblage rond ou rectangulaire dans la zone de la liaison par soudage par ultrasons avec un agrandissement du point de contact d'ultrasons (21).

2. Installation pour la fabrication d'une carte imprimée selon la revendication 1, **caractérisée en ce qu'**une tête de sonotrode (5, 26) disposée à l'horizontale avec un générateur d'ultrasons est disposée au-dessus d'une table et est conçue pour être mobile par rapport à celle-ci avec une commande numérique.

3. Installation pour la fabrication d'une carte imprimée selon la revendication 1, **caractérisée en ce qu'**une tête de sonotrode (6, 26) disposée à la verticale avec un générateur d'ultrasons et un système de torsionoscillation ou un système longitudinal est disposée au-dessus d'une table et est conçue pour être mobile par rapport à celle-ci avec une commande numérique.

4. Installation pour la fabrication d'une carte imprimée selon l'une des revendications 1 à 3, **caractérisée en ce que** la tête de sonotrode (5, 6, 26) avec le générateur d'ultrasons est déplacée dans les sens x et y avec une commande numérique, et la table est disposée de manière à ne pas pouvoir être déplacée.

5. Installation pour la fabrication d'une carte imprimée selon l'une des revendications 1 à 3, **caractérisée en ce que** la table est déplacée dans les sens x et y avec une commande numérique, et la tête de sonotrode (5, 6, 26) avec le générateur d'ultrasons est disposée de manière à ne pas pouvoir être déplacée.

6. Installation pour la fabrication d'une carte imprimée selon l'une des revendications 1 à 3, **caractérisée en ce que** la table est déplacée avec une commande numérique dans une direction, et la tête de sonotrode (5, 6, 26) avec le générateur d'ultrasons dans l'autre direction.

7. Installation pour la fabrication d'une carte imprimée selon l'une des revendications 1 à 6, **caractérisée en ce qu'**un substrat avec une surface de film de cuivre formée de manière appropriée ou un film de cuivre approprié est déposé manuellement sur la table et, après l'opération de pose, est enlevé manuellement, ou l'amenée et l'évacuation se fait de manière entièrement automatique, et **en ce que** le substrat avec le film de cuivre ou le film de cuivre tient solidement sur la table dans une position définie avec précision, à l'aide de systèmes à griffes ou à pinces.

8. Installation pour la fabrication d'une carte imprimée selon l'une des revendications 1 à 7, **caractérisée en ce que** la tête de sonotrode (5, 6, 26) est conçue pour pouvoir tourner, et une pose angulaire d'éléments de câble peut ainsi se faire.

9. Installation pour la fabrication d'une carte imprimée selon l'une des revendications 1 à 8, **caractérisée en ce que** l'outil à sonotrode est conçu pour pouvoir être changé, et peut être changé manuellement ou de manière entièrement automatique.

10. Installation pour la fabrication d'une carte imprimée selon l'une des revendications 1 à 9, **caractérisée en ce que** l'outil à sonotrode est plat et est en titane et peut ainsi nettoyer par zones la surface d'un film de cuivre, et une couche de passivation par oxyde peut ainsi être enlevée.

11. Installation pour la fabrication d'une carte imprimée selon l'une des revendications 1 à 10, **caractérisée en ce qu'**un élément de câblage déjà préfabriqué est positionné avec précision sur la surface en cuivre, à partir d'un magasin, et est ensuite relié pièce par pièce à l'aide de sonotrodes et d'ultrasons.

12. Installation pour la fabrication d'une carte imprimée selon l'une des revendications 1 à 11, **caractérisée en ce que** la tête de sonotrode (5, 6, 26) réalise un aplatissement de la zone de contact d'un fil rond (2) lors du soudage avec la surface opposée.

13. Procédé pour faire fonctionner l'installation pour la fabrication d'une carte imprimée selon l'une des revendications 1 à 12, **caractérisée en ce qu'**une lame d'entaillage (12) est abaissée avec une commande numérique, et l'élément de fil (4) d'une hauteur (17) est entaillé jusqu'à une profondeur d'entaille (18), et **en ce que** le reste de la hauteur non entaillée de l'élément de fil (4) est arraché à l'aide d'un système à pinces (11).
